(19) Europäisches Patentamt
European Patent Office
Office européen des brevets

(11) **EP 4 618 339 A1**

(12) **DEMANDE DE BREVET EUROPEEN**

(43) Date de publication:
**17.09.2025 Bulletin 2025/38**

(21) Numéro de dépôt: **25162536.4**

(22) Date de dépôt: **10.03.2025**

(51) Classification Internationale des Brevets (IPC):
**H02H 3/33** (2006.01)    **H02H 1/06** (2006.01)

(52) Classification Coopérative des Brevets (CPC):
**H02H 3/33; H02H 1/06**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **11.03.2024 FR 2402407**

(71) Demandeur: SCHNEIDER ELECTRIC **INDUSTRIES SAS**
**92500 Rueil-Malmaison (FR)**

(72) Inventeurs:
• **BORDET, Bruno**
**92500 RUEIL MALMAISON (FR)**
• **LENOIR, Vincent**
**92500 RUEIL MALMAISON (FR)**
• **TIAN, Simon**
**92500 RUEIL MALMAISON (FR)**
• **MEUNIER-CARUS, Jérôme**
**92500 RUEIL MALMAISON (FR)**

(74) Mandataire: **Lavoix**
**62, rue de Bonnel**
**69448 Lyon Cedex 03 (FR)**

(54) **DISPOSITIF DE PROTECTION ÉLECTRIQUE DIFFÉRENTIELLE, INSTALLATION ÉLECTRIQUE ET PROCÉDÉ DE COMMANDE ASSOCIÉS**

(57) La présente invention concerne un dispositif (10) de protection électrique différentielle comprenant un circuit d'alimentation (16), configuré pour être alimenté sous une tension d'alimentation ($U_e$), une bobine (21), configurée pour basculer des contacts (23, 24) dans une configuration d'ouverture, un élément de commande (26), configuré pour basculer entre un état passant et un état bloqué, et une unité électronique de contrôle (18) comprenant un module de régulation d'alimentation (42), configuré pour mesurer une intensité interne représentative de la tension d'alimentation ($U_e$), et une unité de traitement d'information (90) configurée pour déterminer une phase de la tension d'alimentation ($U_e$), l'unité de traitement d'information (90) comprenant un module de commande, configuré pour commander l'élément de commande (26) dans l'état passant lorsqu'un module de détection détecte un défaut différentiel et que la phase de la tension d'alimentation ($U_e$) est égale à une phase de déclenchement.

FIG.1

EP 4 618 339 A1

**Description**

La présente invention concerne un dispositif de protection électrique différentielle, une installation électrique et un procédé de commande associés.

Pour interrompre la circulation d'un courant dans un circuit comprenant une source et une charge suite à un défaut différentiel, il est connu d'utiliser un dispositif de protection électrique différentielle. US20140146424A1, US6094329A1 et JPS59165914A décrivent de tels dispositifs de protection électrique. De manière connue, ces dispositifs comprennent généralement une bobine. En cas de défaut différentiel, la bobine bascule dans un état actif dans lequel elle est parcourue par un courant, et génère une force suffisante pour déplacer des contacts, et ouvrir le circuit. Dans les dispositifs connus, le courant parcourant la bobine n'est pas mesuré et ses caractéristiques sont donc inconnues. Pour s'assurer de l'ouverture des contacts, sans information sur les caractéristiques du courant parcourant la bobine, l'état actif de la bobine est généralement maintenu pendant plus de 30ms, par exemple entre 35 et 60ms, pour s'assurer qu'un courant suffisant pour déplacer les contacts parcourt la bobine. Cependant, cela génère une usure prématurée de la bobine, qui limite la durée de vie de cette dernière et plus généralement, du dispositif de protection électrique différentielle.

Le but de l'invention est alors de proposer un dispositif permettant de limiter l'usure de la bobine.

A cet effet, l'invention a pour objet un dispositif de protection électrique différentielle, configuré pour être connecté entre une source et une charge, le dispositif comprenant :

- un circuit d'alimentation, configuré pour être connecté à la source, et pour être alimenté électriquement par la source sous une tension d'alimentation alternative, variable au cours du temps ;
- des contacts, configurés pour basculer dans une configuration d'ouverture, dans laquelle la source et la charge sont isolées l'une de l'autre, et dans une configuration de fermeture, dans laquelle la source et la charge sont connectées l'une à l'autre ;
- un détecteur différentiel, configuré pour mesurer une intensité différentielle d'un courant différentiel circulant dans la charge et émettre un signal de défaut représentatif de l'intensité différentielle ;
- une bobine, configurée pour basculer dans un état de repos et dans un état actif, dans lequel la bobine bascule les contacts dans la configuration d'ouverture depuis la configuration de fermeture ; et
- un élément de commande, configuré pour basculer entre un état passant, dans lequel l'élément de commande permet une alimentation de la bobine qui bascule alors dans l'état actif, et un état bloqué, dans lequel l'élément de commande empêche l'alimentation de la bobine qui bascule alors dans l'état de repos ; et

- une unité électronique de contrôle comprenant :

  ○ un module de régulation d'alimentation, connecté au circuit d'alimentation, comprenant un détecteur de courant, configuré pour mesurer une intensité interne d'un courant interne circulant dans le module de régulation d'alimentation, l'intensité interne étant représentative de la tension d'alimentation ; et
  ○ une unité de traitement d'information configurée pour déterminer une phase de la tension d'alimentation à partir de l'intensité interne mesurée par le détecteur de courant, l'unité de traitement d'information comprenant un module de détection, configuré pour détecter un défaut différentiel à partir du signal de défaut émis par le détecteur différentiel et un module de commande, configuré pour commander l'élément de commande dans l'état passant lorsque le module de détection détecte un défaut différentiel et que la phase de la tension d'alimentation, déterminée par l'unité de traitement d'information à partir de l'intensité interne, est égale à une phase de déclenchement.

Grâce à l'invention, lorsqu'un défaut différentiel est détecté, l'élément de commande est commandé dans l'état passant seulement lorsque la phase de la tension d'alimentation est égale à la phase de déclenchement. La phase de la tension d'alimentation est directement reliée à un courant parcourant la bobine lorsqu'elle est en état actif. Ainsi, la connaissance de la phase de la tension d'alimentation permet de déterminer le courant passant dans la bobine, notamment une phase du courant passant dans la bobine. La bascule de la bobine dans l'état actif est synchronisée avec la phase de la tension d'alimentation, et permet de limiter au strict nécessaire le courant passant dans la bobine, en choisissant la phase de déclenchement. Ainsi, l'usure prématurée de la bobine est limitée.

Suivant d'autres aspects avantageux de l'invention, le dispositif comprend une ou plusieurs des caractéristiques suivantes, prises isolément ou suivant toutes les combinaisons techniquement possibles :

- L'unité de traitement d'information détermine que la phase de la tension d'alimentation est égale à la phase de déclenchement, en détectant un extremum de l'intensité interne, et en attendant qu'une durée de synchronisation, mesurée à partir du moment où l'extremum de l'intensité interne est détecté, soit écoulée.
- L'unité de traitement d'information est, en outre, configurée pour déterminer une valeur efficace de la tension d'alimentation à partir de l'intensité interne, et dans lequel lorsque la valeur efficace de la tension d'alimentation est inférieure ou égale à un seuil de valeur efficace, la phase de déclenchement est égale à Nπ avec N égal à 0, 1 ou 2, et lorsque la valeur efficace de la tension d'alimentation est supérieure au seuil de valeur efficace, la phase de déclenchement est égale à Kπ/2, avec K égal à 1 ou 3.

- L'unité de traitement d'information est configurée, en outre, pour calculer une durée de commande de l'élément de commande dans l'état passant par le module de commande en fonction de la valeur efficace de la tension d'alimentation.
- Les contacts sont connectés entre le circuit d'alimentation et la charge ;

  - le module de détection est configuré, en outre, pour comparer le signal de défaut à un seuil de défaut, un défaut différentiel étant détecté lorsque le signal de défaut est supérieur au seuil de défaut, et est configuré, en outre, pour comparer le signal de défaut à un seuil de fin de défaut ; et
  - le module de commande est configuré, en outre, pour commander l'élément de commande dans l'état bloqué lorsque le signal de défaut est inférieur ou égal au seuil de fin de défaut, le module de commande ayant commandé l'élément de commande dans l'état passant.

- Le module de commande est configuré pour commander l'élément de commande dans l'état passant en émettant un signal de commande sous la forme d'au moins une impulsion.
- Le signal de commande est sous la forme d'une pluralité d'impulsions, chaque front montant d'impulsion étant séparé du front montant de l'impulsion suivante par une durée égale à une demi-période de la tension d'alimentation.
- Le signal de commande est sous la forme de deux impulsions, le front montant des deux impulsions étant séparées d'une durée égale à une demi-période de la tension d'alimentation.

L'invention concerne également une installation électrique comprenant une source, une charge et un dispositif de protection électrique différentielle ainsi que décrit précédemment.

L'invention concerne également un procédé de commande d'un dispositif de protection électrique différentielle ainsi que décrit précédemment, le procédé comprenant au moins les étapes suivantes :

- mesure de l'intensité différentielle circulant dans la charge par le détecteur différentiel et émission du signal de défaut ;
- mesure de l'intensité interne par le détecteur de courant ;
- détection par le module de détection d'un défaut différentiel à partir du signal de défaut émis par le détecteur différentiel ;

- détermination de la phase de la tension d'alimentation à partir de l'intensité interne mesurée par le détecteur de courant, par l'unité de traitement d'information ; et

commande de l'élément de commande dans l'état passant par le module de commande, le module de détection ayant détecté un défaut différentiel et la phase de la tension d'alimentation, déterminé par l'unité électronique de contrôle à partir de l'intensité interne, étant égale à la phase de déclenchement.

Avantageusement, la phase de déclenchement est choisie parmi le groupe suivant : Nπ, N étant égal à 0, 1 ou 2 ; et, Kπ/2, K étant égal à 1 ou à 3.

L'invention apparaîtra plus clairement à la lecture de la description qui va suivre, donnée uniquement à titre d'exemple non limitatif, et faite en référence aux dessins dans lesquels :

- [Fig. 1] la figure 1 est un schéma d'un circuit électrique comprenant un dispositif de protection électrique différentielle selon l'invention ;
- [Fig. 2] la figure 2 est un schéma de principe d'un module de régulation d'une unité electronique de contrôle selon l'invention ;
- [Fig. 3] la figure 3 est un graphe de tension et d'intensités dans le dispositif selon l'invention lorsqu'une tension d'alimentation est égale à une première valeur;
- [Fig. 4] la figure 4 est un graphe montrant l'évolution générale de tension et d'intensités dans le dispositif lorsqu'un défaut différentiel est présent dans une installation comprenant le dispositif lorsque la tension d'alimentation est égale à la première valeur ;
- [Fig. 5] la figure 5 est un graphe de tension et d'intensités dans le dispositif selon l'invention lorsque la tension d'alimentation est égale à une deuxième valeur ; et
- [Fig. 6] la figure 6 est un logigramme d'un procédé de commande mis en œuvre par le dispositif selon l'invention.

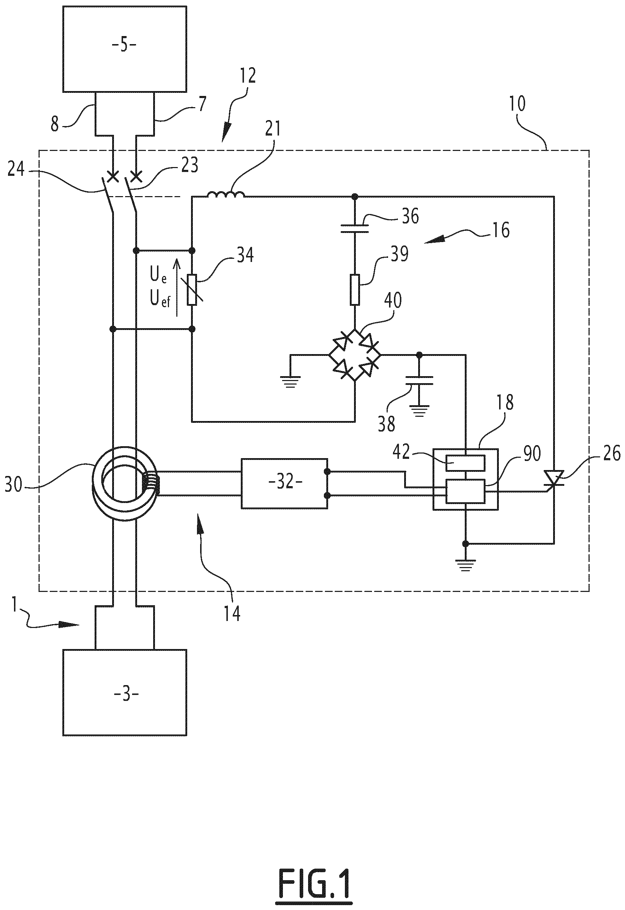

La figure 1 est un schéma d'un circuit électrique 1, ou installation électrique, comprenant une source 3 et une charge 5, reliées entre elles par un conducteur de phase 7 et un conducteur de neutre 8. La source 3 fournit de l'électricité et est par exemple générateur électrique ou un réseau électrique national. La charge 5 est de manière générale un dispositif consommant de l'électricité, comme un appareil électrique domestique ou un équipement industriel.

Un dispositif de protection électrique différentielle 10, aussi appelé dispositif de protection 10 est connecté entre la source 3 et la charge 5.

Le dispositif de protection 10 comprend un mécanisme d'ouverture 12, un détecteur différentiel 14, un circuit d'alimentation 16 et une unité électronique de contrôle 18, connectée au mécanisme d'ouverture 12, au détecteur différentiel 14 et au circuit d'alimentation 16.

Le mécanisme d'ouverture 12 comprend une bobine 21, des contacts 23 et 24 et un élément de commande 26. Les contacts 23 et 24 sont respectivement un contact de phase 23 et un contact de neutre 24.

Les contacts 23 et 24 sont configurés pour basculer dans une configuration d'ouverture, isolant ainsi la source 3 et la charge 5 l'une de l'autre. Le dispositif de protection 10 est alors dit déclenché. Les contacts 23 et 24 sont également configurés pour basculer dans une configuration de fermeture, la source 3 et la charge 5 étant ainsi connectées électriquement l'une à l'autre. Le dispositif de protection 10 est alors dit armé, autrement dit, est fermé.

La bobine 21 est configurée pour basculer dans un état de repos, et dans un état actif. Dans l'état actif, la bobine 21 bascule les contacts 23 et 24 dans la configuration d'ouverture depuis la configuration de fermeture. Autrement dit, la bobine 21 agit comme un déclencheur afin de basculer les contacts 23 et 24 de la configuration de fermeture à la configuration d'ouverture.

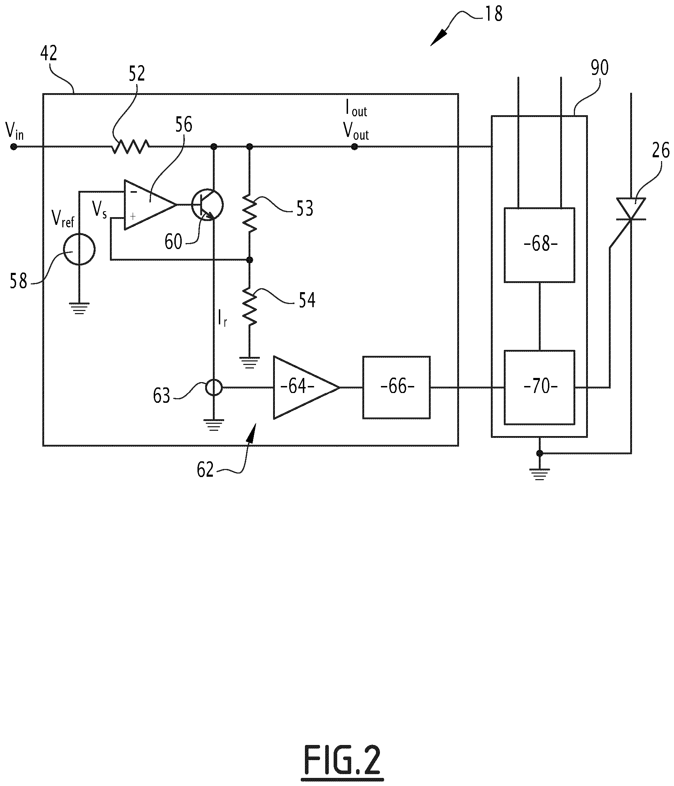

L'élément de commande 26 est avantageusement un composant semi-conducteur commandable en commutation, par exemple un thyristor, ainsi que représenté sur les figures 1 et 2. La tension d'alimentation est appliquée aux bornes de l'élément de commande 26. L'élément de commande 26 est configuré pour basculer entre un état passant et dans un état bloqué. Dans l'état passant, l'élément de commande 26 permet l'alimentation de la bobine 21. La bobine 21 bascule alors dans l'état actif. Dans l'état bloqué, l'élément de commande 26 bloque l'alimentation de la bobine 21. La bobine 21 bascule alors dans l'état de repos. Les détails de la commande et de l'ouverture seront décrits plus en détail plus loin.

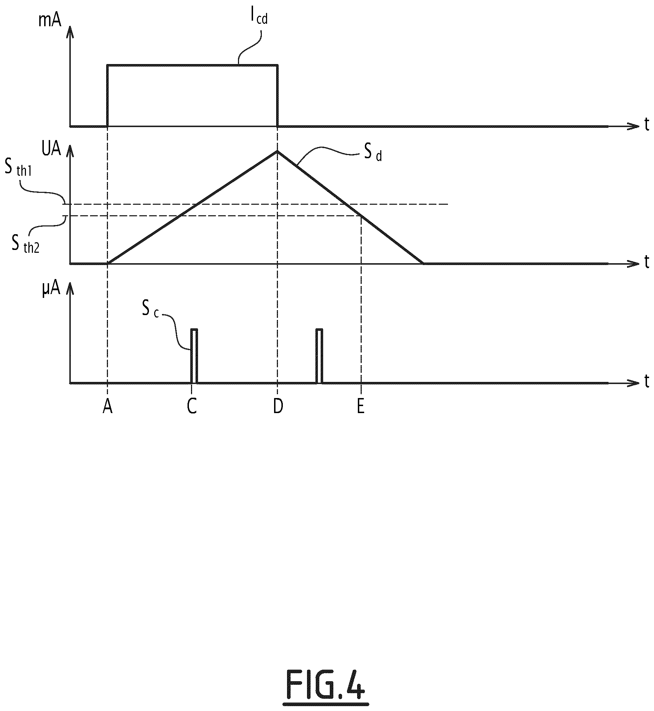

Le détecteur différentiel 14 est configuré pour mesurer un courant différentiel ayant une intensité différentielle $I_{cd}$ entre le conducteur de phase 7 et le conducteur de neutre 8. Le détecteur différentiel 14 comprend un transducteur 30, qui est un tore, dans l'exemple de la figure 1. Lorsqu'un défaut différentiel est présent dans la charge 5, ou éventuellement dans des connecteurs entre le dispositif de protection 10 et la charge 5, l'intensité différentielle $I_{cd}$ est non nulle, générant un courant induit dans le tore 30. Le détecteur différentiel 14 comprend également une unité de conditionnement 32. L'unité de conditionnement 32 est reliée au tore 30, et comprend notamment des filtres, afin de stabiliser le courant induit dans le tore 30 et améliorer une qualité de la mesure de courant différentiel entre le conducteur de phase 7 et le conducteur de neutre 8. L'unité de conditionnement 32 est configurée pour émettre un signal de défaut $S_d$, qui est représentatif de l'intensité différentielle $I_{cd}$. Par exemple, le signal de défaut $S_d$ est une intégrale par rapport au temps de l'intensité différentielle $I_{cd}$. Dans l'exemple de la figure 4, le signal de défaut $S_d$ est exprimé en unité arbitraires, ou UA.

Le circuit d'alimentation 16 est connecté à la source 3. Dans l'exemple de la figure 1, le circuit d'alimentation 16 est connecté à la source 3 via les conducteurs de phase 7 et de neutre 8 en amont des contacts 23 et 24. Autrement dit, le circuit d'alimentation 16 est connecté entre la source 3 et les contacts 23 et 24. La source 3 alimente électriquement le circuit d'alimentation 16 avec un courant électrique, dit courant d'alimentation, que les contacts 23, 24 soient en configuration d'ouverture ou de fermeture. Selon une variante non représentée, le circuit d'alimentation 16 est connecté aux conducteurs de phase 7 et de neutre 8 en aval des contacts 23 et 24. Dans ce cas le circuit d'alimentation 16 n'est alimenté par le courant d'alimentation que lorsque les contacts 23, 24 sont en configuration de fermeture.

Dans l'exemple de la figure 1, une tension d'alimentation $U_e$ est appliquée en permanence au circuit d'alimentation 16, notamment aux bornes d'un varistor 34 inclus dans le circuit d'alimentation 16. La tension d'alimentation $U_e$ est égale à une tension délivrée par la source 3. La tension d'alimentation $U_e$ est une tension alternative de phase comprise entre 0 et $2\pi$, et a une valeur efficace $U_{ef}$ aussi appelée tension efficace, par exemple égale à 230V.

La tension efficace $U_{ef}$ peut varier dans le temps de façon imprévisible, par exemple à cause de légères fluctuations sur un réseau électrique alimentant la source 3, où suite à un dysfonctionnement de la source 3 ou du réseau électrique alimentant la source 3. Ainsi, la tension d'alimentation $U_e$ est variable dans le temps de par son caractère alternatif et aussi car sa valeur efficace $U_{ef}$ est potentiellement variable dans le temps.

Le circuit d'alimentation 16 comprend, en outre, dans le mode de réalisation décrit, une capacité d'alimentation 36, une capacité de filtrage 38, une résistance 39 et un pont de diodes 40.

Le circuit d'alimentation 16 convertit le courant d'alimentation en un courant d'entrée redressé via le pont de diodes 40, et déphasé d'un quart de période, autrement dit de $\pi/2$ par rapport à la tension d'alimentation $U_e$ à cause de la présence de la capacité d'alimentation 36. Le courant d'entrée a une tension appelée tension d'entrée $V_{in}$, de valeur efficace inférieure à la valeur efficace $U_{ef}$ de la tension d'alimentation $U_e$. La tension d'entrée $V_{in}$ est appliquée en entrée de l'unité électronique de contrôle 18. Le circuit d'alimentation 16 assure ainsi une alimentation électrique de l'unité électronique de contrôle 18 adaptée, c'est-à-dire de courant et tension $V_{in}$ redressés et inférieurs aux courant et tension délivrés par la source 3, pour éviter d'endommager l'unité électronique de contrôle 18 en l'alimentant avec un courant de tension et d'intensité trop élevés et alternatifs.

L'unité électronique de contrôle 18 comprend un module de régulation d'alimentation 42. Le module de régulation d'alimentation 42 est représenté en détail à la figure 2. Le module de régulation d'alimentation 42 comprend des résistances 52, 53 et 54, un amplificateur opérationnel 56, une référence de tension 58 et un élément de contrôle 60. L'élément de contrôle 60 est par exemple mis en oeuvre par un transistor de type MOS, ou encore un transistor bipolaire. Le module de régulation d'alimentation 42 est ici un module de régulation de type shunt piloté par l'amplificateur opérationnel 56.

Les résistances 53 et 54 sont connectées en série l'une de l'autre, et en parallèle de l'élément de contrôle 60. Une borne non inverseuse de l'amplificateur opérationnel 56 est connectée entre les résistances 53 et 54, une borne inverseuse de l'amplificateur opérationnel 56 est connectée à la référence de tension 58 et l'élément de contrôle 60 est connecté en sortie de l'amplificateur opérationnel 56.

Lorsque le mécanisme d'ouverture 12 est en configuration de fermeture, la tension d'entrée $V_{in}$ est appliquée en entrée du module de régulation d'alimentation 42, une tension de sortie $V_{out}$ et une intensité de sortie $I_{out}$ sont générées en sortie du module de régulation d'alimentation 42 et un courant interne, d'intensité dite intensité interne $I_r$, circule dans le module de régulation d'alimentation 42, plus précisément dans l'élément de contrôle 60. L'intensité interne $I_r$ est de phase identique à celle de la tension d'entrée $V_{in}$, c'est-à-dire déphasée de $\pi/2$ par rapport à la tension d'alimentation $U_e$.

L'amplificateur opérationnel 56 fonctionne comme un comparateur et compare une différence entre une tension de référence $V_{ref}$ appliquée à la borne inverseuse par la référence de tension 58 et une tension échantillon $V_s$ prélevée entre les résistances 53 et 54.

En cas de variation de la tension d'entrée $V_{in}$, la tension échantillon $V_s$ varie et devient différente de la tension de référence $V_{ref}$. L'amplificateur opérationnel 56 contrôle une ouverture ou une fermeture plus ou moins importante de l'élément de contrôle 60 afin de faire varier l'intensité interne $I_r$ circulant dans l'élément de contrôle 60 et ainsi, maintient la tension de sortie $V_{out}$ constante.

Le module de régulation d'alimentation 42 comprend en outre un détecteur de courant 62, pour mesurer l'intensité interne $I_r$, visible à la figure 2. Le détecteur de courant 62 comprend un dispositif de mesure 63, un amplificateur opérationnel 64 connecté au dispositif de mesure 63 et un convertisseur analogique numérique 66, connecté en sortie de l'amplificateur opérationnel 64. Le dispositif de mesure 63 est par exemple une résistance de shunt, ou un montage à miroir de courant, et mesure l'intensité interne $I_r$.

L'amplificateur opérationnel 64 amplifie la mesure réalisée par le dispositif de mesure 63, et le convertisseur analogique numérique 66 convertit le signal reçu en signal numérique utilisé par une unité de traitement d'information 90, incluse dans l'unité de contrôle 18. L'intensité interne $I_r$ est représentative de la tension d'alimentation $U_e$.

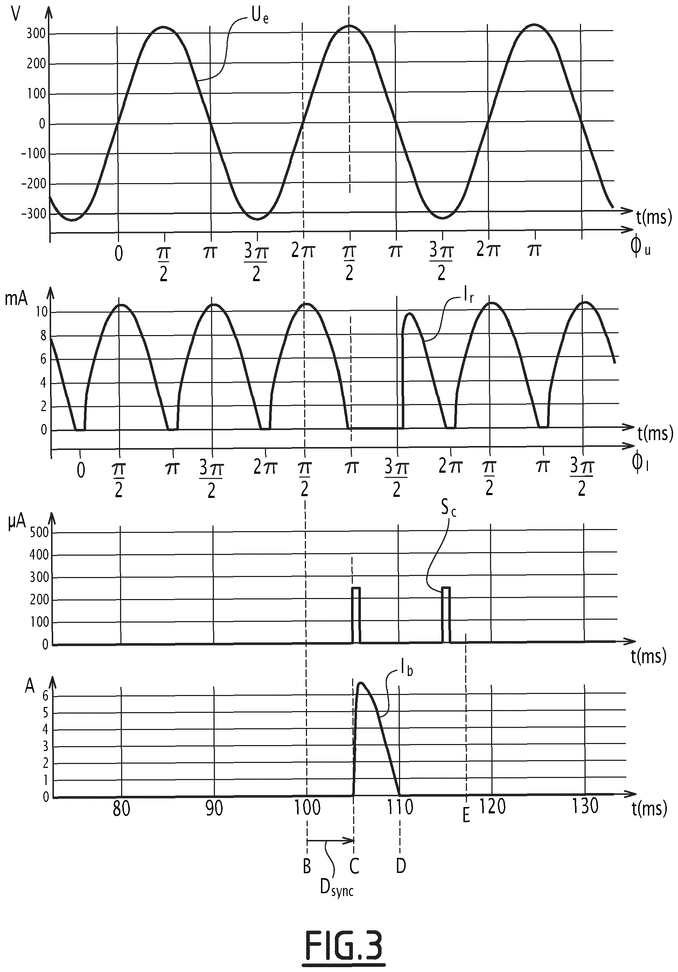

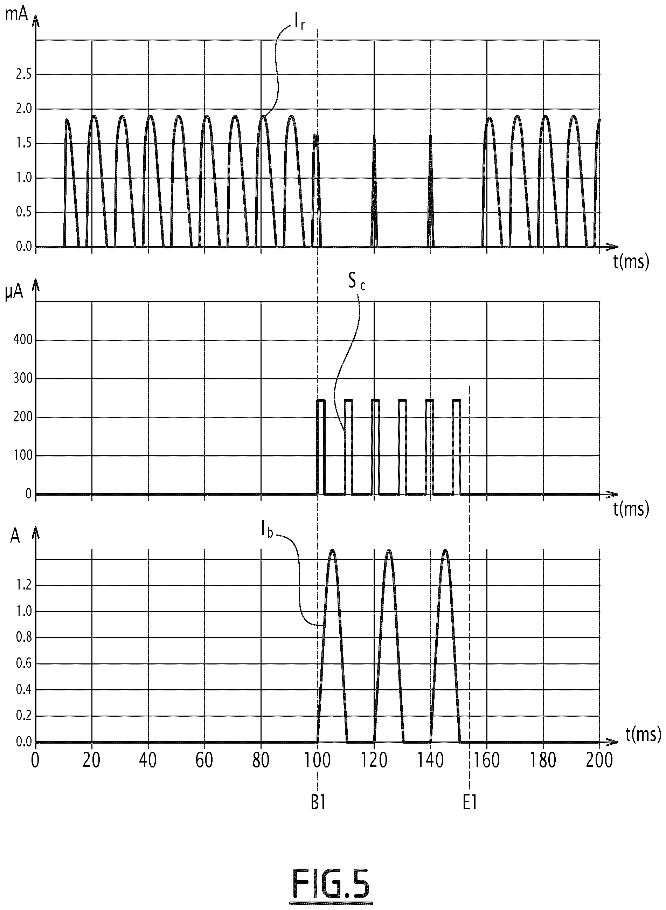

En particulier, l'unité de traitement d'information 90 est avantageusement configurée pour déterminer les maxima de l'intensité interne $I_r$. La détermination des maxima de l'intensité interne $I_r$ est par exemple réalisée en détectant une annulation ou un changement de signe de la dérivée de l'intensité interne $I_r$. La détermination des maxima de l'intensité interne $I_r$ permet de déduire les moments où une phase $\Phi_I$ de l'intensité interne $I_r$ est égale à $K\pi/2$ avec K égal à 1 ou 3 et, en tenant compte du déphasage causé par la capacité d'alimentation 36, de déduire une phase $\Phi_U$ de la tension d'alimentation $U_e$ à une demi-période près. En effet, l'intensité interne $I_r$ étant redressée, il n'est pas possible de déterminer la valeur exacte de K, et donc de savoir si un maxima de l'intensité interne $I_r$ correspond à un maximum ou à un minimum de la tension d'alimentation $U_e$. Dans les exemples des figures 3 et 5, l'intensité interne $I_r$ est déphasée de $\pi/2$ par rapport à la tension d'alimentation $U_e$, donc un maximum d'intensité interne $I_r$ a lieu simultanément à un passage par zéro de la tension d'alimentation $U_e$. Autrement dit, au moment où la phase $\Phi_I$ de l'intensité interne $I_r$ est égale à $K\pi/2$, la phase $\Phi_U$ de la tension d'alimentation est égale à $N\pi$, avec N égal à 0, 1 ou 2, sans possibilité de déterminer la valeur exacte de N.

La détection des maxima permet également à l'unité de traitement d'information 90 de déterminer une fréquence de la tension d'alimentation $U_e$. La fréquence de la tension d'alimentation est généralement sensiblement égale à 50Hz, donc une période de la tension d'alimentation $U_e$ est sensiblement égale à 20ms.

En variante non représentée, l'unité de traitement d'information 90 est configurée pour déterminer les minima de l'intensité interne $I_r$, c'est-à-dire les passages à zéro de l'intensité interne $I_r$. Par passage à zéro d'une grandeur, on entend l'annulation de la grandeur.

En variante non représentée, l'unité de traitement d'information 90 est configurée pour détecter les extrema de l'intensité interne, c'est-à-dire à la fois les maxima et les passages à zéro de l'intensité interne $I_r$.

Avantageusement, l'unité de traitement d'information 90 est configurée en outre pour déterminer la valeur efficace $U_{ef}$ de la tension d'alimentation $U_e$ à partir de la mesure de l'intensité interne $I_r$.

Par exemple, la valeur efficace $U_{ef}$ de la tension d'alimentation $U_e$ est obtenue par la formule suivante :

$$U_{ef} = Z \times I_{rmax} + K$$

Avec Z une impédance équivalente du circuit d'alimentation 16, Z étant connue,

$I_{rmax}$ la valeur maximale de l'intensité interne $I_r$,
K une constante telle que $K = Z \times I_{out} + V_d + V_{out}$,
$V_d$ étant une tension de déchet du module de régulation d'alimentation 42, qui est connue.

L'unité de traitement d'information 90 comprend en outre un module de détection de défaut différentiel 68, aussi appelé module de détection, connecté à l'unité de conditionnement 32.

L'unité de traitement d'information 90 comprend également un module de commande 70, connecté au module de détection 68 et connecté à la gâchette du thyristor 26.

De manière avantageuse et non représentée, l'unité de traitement d'informations 90 est formée par exemple d'une mémoire, et d'un processeur, le processeur étant associé à la mémoire. En variante, le processeur est une unité logique câblée. Le module de détection 68, et le module de commande 70, sont alors réalisés chacun sous forme d'un logiciel, ou d'une brique logicielle, exécutable par le processeur. La mémoire de l'unité électronique de contrôle 18 est alors apte à stocker un logiciel de détection de défaut différentiel, ainsi qu'en complément facultatif, un logiciel de commande.

En variante, chaque module 68 et 70 peut être réalisé sous la forme d'unités logiques programmées ou câblées, utilisant par exemple de la logique combinatoire et/ou séquentielle, tel qu'un microcontrôleur, un FPGA, de l'anglais *Field Programmable Gate Array,* ou encore d'un circuit intégré, tel qu'un ASIC, de l'anglais *Application Specific Integrated Circuit.* Le processeur est alors apte à exécuter chacun des logiciels parmi le logiciel de détection de défaut différentiel et le logiciel de commande.

Un procédé de commande du dispositif de protection 10 est décrit ci-dessous, en référence aux figures 3 à 6. Les figures 3 et 4 représentent un premier exemple dans lequel le procédé de commande est mis en oeuvre dans un cas où la tension efficace $U_{ef}$ est égale à 230V.

De manière avantageuse, le dispositif 10 est dans un état initial, dans lequel les contacts 23, 24 sont en configuration fermée, le thyristor 26 est dans l'état bloqué et la bobine 21 est dans l'état de repos. L'unité électronique de contrôle 18 est alimentée par le circuit d'alimentation 16. De ce fait, un faible courant, de l'ordre de quelques centaines de microampères, circule dans la bobine 21, mais il est insuffisant pour que la bobine 21 bascule les contacts 23 et 24 dans la configuration d'ouverture, et est sensiblement nul. Une intensité $I_b$ circulant dans la bobine 21 est donc sensiblement nulle.

Une étape S100 consiste en une mesure de l'intensité différentielle $I_{cd}$ par le détecteur différentiel 14, et émission du signal de défaut $S_d$.

Une étape S102 consiste en une mesure de l'intensité interne $I_r$ par le détecteur de courant 62.

Avantageusement, les étapes S100 et S102 sont réalisées en continu et en variante ou en complément, l'étape S102 est réalisée en parallèle de l'étape S100.

Lors d'une étape S104, le module de détection 68 détecte un défaut différentiel à partir du signal de défaut $S_d$. De manière avantageuse, lors de l'étape S104, le module de détection 68 compare le signal de défaut $S_d$ à un seuil de défaut $S_{th1}$. Si le signal de défaut $S_d$ est inférieur ou égal au seuil de défaut $S_{th1}$, alors le processus effectue à nouveau l'étape S100 et un processus itératif est mis en oeuvre.

Lorsqu'un défaut différentiel est présent dans la charge 5 ou dans les connecteurs entre le dispositif de protection 10 et la charge 5, l'intensité différentielle $I_{cd}$ augmente. Cela est visible à l'instant A de la figure 4. Le signal $S_d$, étant l'intégrale par rapport au temps de l'intensité différentielle $I_{cd}$, augmente au cours du temps, jusqu'à devenir supérieur au seuil de défaut $S_{th1}$. Lors de l'étape S104, le module de détection 68 détecte alors un défaut différentiel.

L'unité de traitement d'information 90 détermine la phase $\Phi_U$ de la tension d'alimentation $U_e$ à partir de l'intensité interne $I_r$ mesurée par le détecteur de courant 62 lors d'une étape S106. De manière avantageuse, l'unité de traitement d'information 90 détecte les maxima de l'intensité interne $I_r$, et en déduit la phase $\Phi_I$ de l'intensité interne $I_r$. La connaissance du déphasage entre l'intensité interne $I_r$ et la tension d'alimentation $U_e$ permet à l'unité de traitement d'information 90 d'en déduire la phase $\Phi_U$ de la tension d'alimentation $U_e$.

Avantageusement, lors de l'étape S106, l'unité de traitement d'information 90 détermine également la fréquence de la tension d'alimentation $U_e$, et/ou la tension efficace $U_{ef}$ à partir de l'intensité interne $I_r$.

En variante non représentée, l'étape S106 est réalisée en parallèle des étapes S100 et S102.

De manière particulièrement avantageuse, l'unité de traitement d'information 90 compare la tension efficace $U_{ef}$ déterminée à l'étape S106 à un seuil de valeur efficace lors d'une étape S107. Si la tension efficace $U_{ef}$ est supérieure au seuil de valeur efficace, une phase de déclenchement $\Phi_d$ est égale à $K\pi/2$, avec K égal à 1 ou 3. Si la tension efficace $U_{ef}$ est inférieure ou égale au seuil de valeur efficace, alors la phase de déclenchement $\Phi_d$ est égale à $N\pi$, avec N égal à 0, 1 ou 2. La phase de déclenchement $\Phi_d$ est ainsi une valeur prédéterminée de la phase $\Phi_U$ de la tension d'alimentation $U_e$. La valeur de la phase de déclenchement $\Phi_d$ est choisie en fonction des caractéristiques de l'installation électrique 1, et notamment de la valeur de la tension efficace $U_{ef}$.

Selon un premier exemple, visible à la figure 3, la phase de déclenchement $\Phi_d$ est égale à $K\pi/2$, avec K égal à 1 ou 3. L'unité de traitement d'information 90 détermine alors lors d'une étape S108 si la phase $\Phi_U$ de la tension d'alimentation $U_e$ est égale à la phase de déclenchement $\Phi_d$.

Pour cela, avantageusement, lors de l'étape S108, l'unité de traitement d'information 90 détecte un maximum de l'intensité interne $I_r$. Lorsqu'un maximum de l'intensité interne $I_r$ est détecté, par exemple à un instant B sur la figure 3, la tension d'alimentation $U_e$ s'annule, c'est-à-dire passe par zéro, autrement dit, la phase $\Phi_U$ de la tension d'alimentation $U_e$ est égale à $N\pi$ avec N égal à 0, 1 ou 2. Ainsi que mentionné précédemment, il n'est pas possible de déterminer si N est égal à 0, 1 ou 2.

Connaissant la fréquence de la tension d'alimentation $U_e$, l'unité de traitement d'information 90 détermine une durée de synchronisation $D_{sync}$ à partir de l'instant où le maximum d'intensité interne $I_r$ est détecté, permettant d'obtenir la phase $\Phi_U$ de la tension d'alimentation $U_e$ égale à la phase de déclenchement $\Phi_d$. La

durée de synchronisation $D_{sync}$ est dans cet exemple égale à un quart de période de la tension d'alimentation $U_e$.

L'unité de traitement d'information 90 attend que la durée de synchronisation $D_{sync}$ soit écoulée. Dès que la durée de syncrhonisation $D_{sync}$ est écoulée, la phase $\Phi_U$ de la tension d'alimentation $U_e$ égale à la phase de déclenchement $\Phi_d$ et le module de commande 70 commande le thyristor 26 en configuration passante lors d'une étape S110 de commande, correspondant à un instant C sur la figure 3.

De manière avantageuse, le module de commande 70 commande le thyristor 26 en émettant un signal de commande $S_c$. Dans l'exemple de la figure 3, le signal de commande $S_c$ est émis sur la gâchette du thyristor 26 sous la forme d'au moins une impulsion, ici deux impulsions courtes, de durée de l'ordre de 1 à 2ms. Le front montant de chacune des deux impulsions est séparé par une durée égale à une demi-période de la tension d'alimentation $U_e$, par exemple 10ms.

En effet, il a été mentionné qu'il n'est pas possible de connaître la valeur de N à partir de la mesure de l'intensité interne $I_r$. Ainsi, il n'est pas possible de déterminer si la tension $U_e$ est positive ou négative à partir de la mesure de $I_r$. Envoyer deux impulsions espacées d'une demi-période de la tension $U_e$ permet de rendre le thyristor 26 passant de manière certaine. Une fois amorcé, le thyristor 26 reste passant tant que la tension d'alimentation $U_e$ à ses bornes est positive, ce qui a lieu entre les instants C et D de la figure 3, autrement dit, pendant un quart de période de la tension d'alimentation $U_e$.

L'intensité $I_b$ dans la bobine 21 devient égale à l'intensité du courant d'alimentation entre les instants C et D, autrement dit est égale à un quart de période positif de l'intensité du courant d'alimentation, et génère un champ magnétique qui bascule les contacts 23 et 24 dans la configuration d'ouverture depuis la configuration de fermeture. Autrement dit, lorsque le thyristor 26 est commandé en configuration passante, la bobine 21 bascule dans l'état actif et bascule les contacts 23 et 24 dans la configuration d'ouverture à un instant D visible sur les figures 3 et 4. Le courant circulant entre la source 3 et la charge 5 est interrompu, l'intensité différentielle $I_{cd}$ devient nulle, et le signal de défaut $S_d$ diminue.

Lorsque le thyristor 26 est en configuration passante, il court-circuite le circuit d'alimentation 16 et l'unité électronique de contrôle 18. Le condensateur 38 assure l'alimentation de l'unité de traitement d'information 90, qui requiert pour fonctionner une intensité de l'ordre de quelques centaines de microampères. Dès que le thyristor 26 est en configuration bloquée, le circuit d'alimentation 16 alimente à nouveau l'unité électronique de contrôle 18.

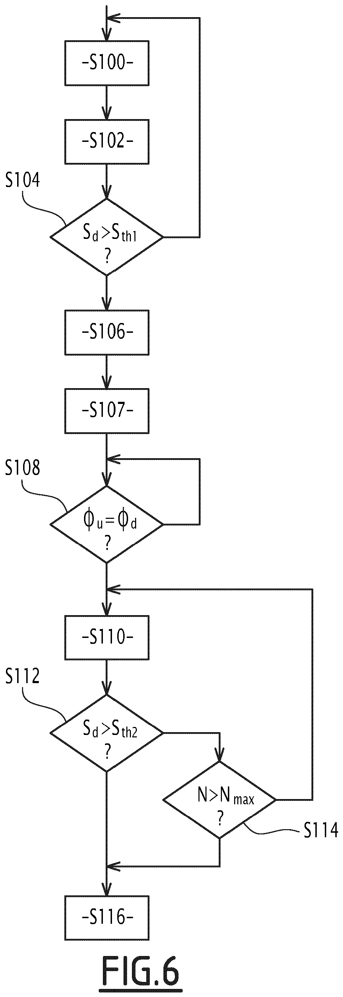

De manière particulièrement avantageuse et optionnelle, le module de détection 68 compare le signal de défaut $S_d$ à un seuil de fin de défaut $S_{th2}$ à l'étape S112. Le seuil de fin de défaut $S_{th2}$ est dans l'exemple des figures 4 et 6, distinct du seuil de défaut $S_{th1}$, mais en variante, est égal au seuil de défaut $S_{th1}$.

Si le signal de défaut $S_d$ est supérieur au seuil de fin de défaut $S_{th2}$, alors l'unité de traitement d'information 90 détermine si le nombre d'impulsions N du signal de commande $S_c$ est supérieur à un nombre maximum d'impulsions $N_{max}$ à l'étape S114. Si ce n'est pas le cas, le module de commande 70 effectue à nouveau l'étape de commande S110 et un fonctionnement itératif est mis en œuvre.

Si, lors de l'étape S112, le module de détection 68 détermine que le signal de défaut $S_d$ est inférieur ou égal au seuil de fin de défaut $S_{th2}$, alors cela signifie que le défaut différentiel a disparu. Le module de commande 70 effectue l'étape S116 lors de laquelle il arrête d'émettre le signal de commande $S_c$, correspondant à un instant E sur les figures 3 et 4. Le thyristor 26 bascule en configuration bloquée dès que la tension d'alimentation $U_e$ devient négative ou reste en configuration bloquée s'il l'était déjà. Dans l'exemple de la figure 3, le thyristor 26 était déjà en configuration bloquée à l'instant E. Il reste donc en configuration bloquée.

L'intensité $I_b$ qui a parcouru la bobine 21 a donc été limitée au minimum nécessaire pour assurer le basculement des contacts 23 et 24 dans la configuration d'ouverture.

Si le nombre d'impulsions N du signal de commande $S_c$ est supérieur au nombre maximum d'impulsions $N_{max}$, le module de commande 70 effectue également l'étape S116, pour éviter que la bobine 21 soit parcourue par le courant $I_b$ pendant une durée trop importante et soit endommagée.

Les étapes S112 à S116 sont particulièrement avantageuses dans le cas où le circuit d'alimentation 16 est en amont des contacts 23 et 24, c'est-à-dire entre la source 3 et les contacts 23 et 24, et continue donc d'alimenter l'unité de contrôle électronique 18 une fois les contacts 23, 24 en configuration d'ouverture. Elles permettent en effet de déterminer quand arrêter la commande du thyristor 26.

En variante, dans le cas où l'élément de commande 26 n'est pas un thyristor, et est par exemple un transistor unidirectionnel en courant, le signal de commande $S_c$ est sous la forme d'une pluralité d'impulsions dont la durée est égale à un quart de période de la tension d'alimentation $U_e$ et dont le front montant est séparé du front montant de l'impulsion suivante d'une durée égale à une demi-période de la tension d'alimentation $U_e$. Le signal $S_c$ est maintenu pendant une durée de commande prédéterminée, ou, de manière optionnelle, tant que le signal de défaut $S_d$ est supérieur au seuil de fin de défaut $S_{th2}$.

La figure 5 représente un deuxième exemple de mise en oeuvre du procédé de commande du dispositif 10, et correspond à un cas où la tension efficace $U_{ef}$ est égale à 50V. A l'étape S107, l'unité électronique de contrôle détermine que la tension efficace $U_{ef}$ est strictement inférieure au seuil de valeur efficace, alors la phase de déclenchement $\Phi_d$ est égale à $N\pi$, avec N égal

à 0, 1 ou 2.

De manière similaire à ce qui a été décrit précédemment, l'unité de traitement d'information 90 détermine alors à l'étape S108 si la phase $\Phi_U$ de la tension d'alimentation $U_e$ est égale à la phase de déclenchement $\Phi_d$.

Pour cela, avantageusement, lors de l'étape S108, l'unité de traitement d'information 90 détecte un maximum de l'intensité interne $I_r$. Lorsqu'un maximum de l'intensité interne $I_r$ est détecté, par exemple à l'instant B1 sur la figure 5, la tension d'alimentation $U_e$ s'annule, c'est-à-dire passe par zéro, autrement dit, la phase $\Phi_U$ de la tension d'alimentation $U_e$ est égale à $N\pi$ avec N égal à 0, 1 ou 2, ce qui correspond à la phase de déclenchement $\Phi_d$. Dans ce cas, l'unité de traitement d'information 90 détermine que la durée de synchronisation $D_{sync}$ est nulle et le module de commande 70 commande le thyristor 26 en configuration passante à l'étape de commande S110 en émettant le signal de commande $S_c$ à l'instant B1.

Dans l'exemple de la figure 5, le signal de commande $S_c$ est sous la forme d'une pluralité d'impulsions de l'ordre de 1 à 2ms, ici 6 impulsions. Chaque front montant d'impulsion est séparé du front montant de l'impulsion suivante par une durée égale à une demi-période de la tension d'alimentation $U_e$, égale à 5ms dans l'exemple de la figure 5.

Le thyristor 26 est passant lorsqu'il reçoit l'une des impulsions du signal de commande $S_c$ et que la tension d'alimentation $U_e$ à ses bornes est positive. Il est donc passant pendant trois demi-périodes de la tension d'alimentation $U_e$ lors desquelles la tension d'alimentation $U_e$ est positive. L'intensité $I_b$ dans la bobine 21 est alors égale à l'intensité d'alimentation quand le thyristor 26 est passant. Autrement dit, l'intensité $I_b$ est égale à trois demi-périodes positives de l'intensité d'alimentation.

De manière avantageuse, le module de commande 70 émet deux premières impulsions à l'étape de commande S110. L'intensité $I_b$ n'est pas suffisante pour basculer les contacts 23, 24 en configuration d'ouverture. Le courant circulant entre la source 3 et la charge 5 n'est pas interrompu et le défaut différentiel persiste. A l'étape S112, l'unité de traitement d'information 90 détermine que le signal de défaut $S_d$ est supérieur au seuil de fin de défaut $S_{th2}$, effectue l'étape S114 et détermine que le nombre d'impulsion est inférieur au nombre d'impulsion maximum. L'étape de commande S110 est effectuée à nouveau et un fonctionnement itératif est mis en œuvre. En particulier, le module de commande 70 continue d'émettre le signal $S_c$ et émet alors deux nouvelles impulsions à l'étape de commande S110.

Si, lors de l'étape S112, le module de détection 68 détermine que le signal de défaut $S_d$ est inférieur ou égal au seuil de fin de défaut $S_{th2}$, alors cela signifie que le défaut différentiel a disparu. Le module de commande 70 effectue l'étape S116 lors de laquelle il arrête d'émettre le signal de commande $S_c$, correspondant à l'instant E1 sur la figure 5.

En variante, dans le cas où l'élément de commande 26 n'est pas un thyristor, et est par exemple un transistor unidirectionnel en courant, le signal de commande $S_c$ émis à l'étape de commande S110 est sous la forme d'une seule impulsion continue. Le signal $S_c$ est maintenu pendant une durée de commande prédéterminée, ou, de manière optionnelle, tant que le signal de défaut $S_d$ est supérieur au seuil de fin de défaut $S_{th2}$.

En variante applicable quelle que soit la valeur de la tension efficace $U_{ef}$, les étapes S112, S114 et S116 ne sont pas effectuées et l'unité de traitement d'information 90 détermine une durée de commande du thyristor 26 en fonction de la tension efficace $U_{ef}$, pour que la bobine 21 soit parcourue par une intensité $I_b$ suffisante pour assurer un basculement en configuration ouverte des contacts 23 et 24. La durée du signal de commande $S_c$ en fonction de la tension efficace $U_{ef}$ est avantageusement prédéterminée, par exemple imposée par le constructeur du dispositif 10.

Par exemple, si la tension efficace $U_{ef}$ est supérieure au seuil de valeur efficace, la durée du signal de commande $S_c$ est légèrement supérieure à une demi-période de la tension d'alimentation $U_e$, plus précisément égale à la somme d'une demi période de la tension d'alimentation $U_e$ et de la durée d'une impulsion, de sorte que le signal de commande $S_c$ soit formé de deux impulsions.

Selon un autre exemple, si la tension efficace $U_{ef}$ est inférieure ou égale au seuil de valeur efficace, la durée du signal de commande $S_c$ est par exemple égale à la somme deux périodes et demi et de la durée d'une impulsion, de sorte que le signal de commande $S_c$ soit formé de six impulsions.

En variante applicable quelle que soit la valeur de la tension efficace $U_{ef}$, le signal de défaut $S_d$ est généré numériquement et est égal au minimum entre l'intégrale de l'intensité différentielle $I_{cd}$ et du seuil de défaut $S_{th1}$. Autrement dit, le signal de défaut $S_d$ sature lorsqu'il atteint le seuil de défaut $S_{th1}$. Cela permet au signal de défaut $S_d$ d'atteindre le seuil de fin de défaut $S_{th2}$ plus rapidement lorsque le défaut différentiel est interrompu et que l'intensité différentielle $I_{cd}$ devient nulle, et donc permet d'interrompre l'émission du signal $S_c$ le plus tôt possible.

L'invention permet ainsi avantageusement de synchroniser la commande de l'élément de commande 26 sur la tension d'alimentation $U_e$, plus particulièrement sur la phase $\Phi_U$ de la tension d'alimentation $U_e$, afin de limiter l'intensité $I_b$ parcourant la bobine 21 à l'intensité nécessaire pour basculer les contacts 23 et 24 dans la configuration d'ouverture. Cela permet de limiter l'usure de la bobine. De plus, la surveillance de la disparition du signal de défaut permet de s'assurer que le défaut différentiel a disparu de manière certaine avant d'arrêter la commande de l'élément de commande 26. Le dispositif 10 est donc fiabilisé et la durabilité de la bobine 21 est améliorée.

## Revendications

1.  Dispositif (10) de protection électrique différentielle, configuré pour être connecté entre une source (3) et une charge (5), le dispositif (10) comprenant :

    - un circuit d'alimentation (16), configuré pour être connecté à la source (3), et pour être alimenté électriquement par la source (3) sous une tension d'alimentation ($U_e$) alternative, variable au cours du temps ;
    - des contacts (23, 24), configurés pour basculer dans une configuration d'ouverture, dans laquelle la source (3) et la charge (5) sont isolées l'une de l'autre, et dans une configuration de fermeture, dans laquelle la source (3) et la charge (5) sont connectées l'une à l'autre ;
    - un détecteur différentiel (14), configuré pour mesurer une intensité différentielle ($I_{cd}$) d'un courant différentiel circulant dans la charge (5) et émettre un signal de défaut ($S_d$) représentatif de l'intensité différentielle ($I_{cd}$) ;
    - une bobine (21), configurée pour basculer dans un état de repos et dans un état actif, dans lequel la bobine (21) bascule les contacts (23, 24) dans la configuration d'ouverture depuis la configuration de fermeture ;
    - un élément de commande (26), configuré pour basculer entre un état passant, dans lequel l'élément de commande (26) permet une alimentation de la bobine (21) qui bascule alors dans l'état actif, et un état bloqué, dans lequel l'élément de commande (26) empêche l'alimentation de la bobine (21) qui bascule alors dans l'état de repos ; et
    - une unité électronique de contrôle (18) comprenant :

        ◦ un module de régulation d'alimentation (42), connecté au circuit d'alimentation (16), comprenant un détecteur de courant (62), configuré pour mesurer une intensité interne ($I_r$) d'un courant interne circulant dans le module de régulation d'alimentation (42), l'intensité interne ($I_r$) étant représentative de la tension d'alimentation ($U_e$) ; et
        ◦ une unité de traitement d'information (90) configurée pour déterminer une phase ($\Phi_U$) de la tension d'alimentation ($U_e$) à partir de l'intensité interne ($I_r$) mesurée par le détecteur de courant (62), l'unité de traitement d'information (90) comprenant un module de détection (68), configuré pour détecter un défaut différentiel à partir du signal de défaut ($S_d$) émis par le détecteur différentiel (14) et un module de commande (70), configuré pour commander l'élément de commande (26) dans l'état passant lorsque le module de détection (68) détecte un défaut différentiel et que la phase ($\Phi_U$) de la tension d'alimentation ($U_e$), déterminée par l'unité de traitement d'information (90) à partir de l'intensité interne ($I_r$), est égale à une phase de déclenchement ($\Phi_d$).

2.  Dispositif selon la revendication 1, dans lequel l'unité de traitement d'information (90) détermine que la phase ($\Phi_U$) de la tension d'alimentation ($U_e$) est égale à la phase de déclenchement ($\Phi_d$), en détectant un extremum de l'intensité interne, et en attendant qu'une durée de synchronisation ($D_{sync}$), mesurée à partir du moment où l'extremum de l'intensité interne est détecté, soit écoulée.

3.  Dispositif (10) selon l'une quelconque des revendications 1 ou 2, dans lequel l'unité de traitement d'information (90) est, en outre, configurée pour déterminer une valeur efficace ($U_{er}$) de la tension d'alimentation ($U_e$) à partir de l'intensité interne ($I_r$), et dans lequel lorsque la valeur efficace ($U_{er}$) de la tension d'alimentation ($U_e$) est inférieure ou égale à un seuil de valeur efficace, la phase de déclenchement ($\Phi_d$) est égale à $N\pi$ avec N égal à 0, 1 ou 2, et lorsque la valeur efficace ($U_{er}$) de la tension d'alimentation ($U_e$) est supérieure au seuil de valeur efficace, la phase de déclenchement ($\Phi_d$) est égale à $K\pi/2$, avec K égal à 1 ou 3.

4.  Dispositif (10) selon la revendication 3, dans lequel l'unité de traitement d'information (90) est configurée, en outre, pour calculer une durée de commande de l'élément de commande (26) dans l'état passant par le module de commande (70) en fonction de la valeur efficace ($U_{er}$) de la tension d'alimentation ($U_e$).

5.  Dispositif (10) selon l'une quelconque des revendications précédentes, dans lequel :

    - les contacts (23, 24) sont connectés entre le circuit d'alimentation (16) et la charge (5) ;
    - le module de détection (68) est configuré, en outre, pour comparer le signal de défaut ($S_d$) à un seuil de défaut ($S_{th1}$), un défaut différentiel étant détecté lorsque le signal de défaut ($S_d$) est supérieur au seuil de défaut ($S_{th1}$), et est configuré, en outre, pour comparer le signal de défaut ($S_d$) à un seuil de fin de défaut ($S_{th2}$) ; et
    - le module de commande (70) est configuré, en outre, pour commander l'élément de commande (26) dans l'état bloqué lorsque le signal de défaut ($S_d$) est inférieur ou égal au seuil de fin de défaut ($S_{th2}$), le module de commande (70) ayant commandé l'élément de commande (26) dans l'état passant.

**6.** Dispositif (10) selon l'une quelconque des revendications précédentes, dans lequel le module de commande (70) est configuré pour commander l'élément de commande (26) dans l'état passant en émettant un signal de commande ($S_c$) sous la forme d'au moins une impulsion.

**7.** Dispositif (10) selon la revendication 6, dans lequel le signal de commande ($S_c$) est sous la forme d'une pluralité d'impulsions, chaque front montant d'impulsion étant séparé du front montant de l'impulsion suivante par une durée égale à une demi-période de la tension d'alimentation ($U_e$).

**8.** Dispositif (10) selon la revendication 6, dans lequel le signal de commande ($S_c$) est sous la forme de deux impulsions, le front montant des deux impulsions étant séparées d'une durée égale à une demi-période de la tension d'alimentation ($U_e$).

**9.** Installation électrique (1) comprenant une source (3), une charge (5) et un dispositif de protection électrique différentielle (10) selon l'une quelconque des revendications précédentes.

**10.** Procédé de commande d'un dispositif de protection électrique différentielle (10) selon l'une quelconque des revendications 1 à 8, le procédé comprenant au moins les étapes suivantes :

- mesure (S100) de l'intensité différentielle ($I_{cd}$) circulant dans la charge (5) par le détecteur différentiel (14) et émission du signal de défaut ($S_d$) ;
- mesure (S102) de l'intensité interne ($I_r$) par le détecteur de courant (62) ;
- détection (S104) par le module de détection (68) d'un défaut différentiel à partir du signal de défaut ($S_d$) émis par le détecteur différentiel (14) ;
- détermination (S106) de la phase ($\Phi_U$) de la tension d'alimentation ($U_e$) à partir de l'intensité interne ($I_r$) mesurée par le détecteur de courant (62), par l'unité de traitement d'information (90) ; et
- commande (S110) de l'élément de commande (26) dans l'état passant par le module de commande (70), le module de détection (68) ayant détecté un défaut différentiel et la phase ($\Phi_U$) de la tension d'alimentation ($U_e$), déterminé par l'unité électronique de contrôle à partir de l'intensité interne ($I_r$), étant égale à la phase de déclenchement ($\Phi_d$).

**11.** Procédé selon la revendication 10, dans lequel la phase de déclenchement ($\Phi_d$) est choisie parmi le groupe suivant : $N\pi$, N étant égal à 0, 1 ou 2 ; et, $K\pi/2$, K étant égal à 1 ou à 3.

# FIG.1

FIG.2

FIG.3

FIG.4

FIG.5

S104

S108

S112

S114

FIG.6

EP 4 618 339 A1

Europäisches
Patentamt

European
Patent Office

Office européen
des brevets

**RAPPORT DE RECHERCHE EUROPEENNE**

Numéro de la demande

EP 25 16 2536

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2014/146424 A1 (SUEISHI NAOKI [JP]) 29 mai 2014 (2014-05-29) * alinéas [0040] - [0050]; figures 3,4 * ----- | 1-11 | INV. H02H3/33 H02H1/06 |
| A | US 6 094 329 A (HEINZ KLAUS DIETER [DE] ET AL) 25 juillet 2000 (2000-07-25) * colonne 5, ligne 48 - colonne 6; figure 2 * ----- | 1,10 | |
| A | JP S59 165914 A (MITSUBISHI ELECTRIC CORP) 19 septembre 1984 (1984-09-19) * alinéa [0001]; figures 1,2 * ----- | 1,10 | |

DOMAINES TECHNIQUES RECHERCHES (IPC)

H02H

Le présent rapport a été établi pour toutes les revendications

| Lieu de la recherche | Date d'achèvement de la recherche | Examinateur |
|---|---|---|
| Munich | 22 juillet 2025 | Colombo, Alessandro |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 16 2536

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

22-07-2025

| Document brevet cité au rapport de recherche | | Date de publication | Membre(s) de la famille de brevet(s) | | Date de publication |
|---|---|---|---|---|---|
| US 2014146424 | A1 | 29-05-2014 | CN | 103852993 A | 11-06-2014 |
| | | | EP | 2752981 A1 | 09-07-2014 |
| | | | JP | 5793132 B2 | 14-10-2015 |
| | | | JP | 2014107238 A | 09-06-2014 |
| | | | US | 2014146424 A1 | 29-05-2014 |
| US 6094329 | A | 25-07-2000 | AT | E244948 T1 | 15-07-2003 |
| | | | AU | 717339 B2 | 23-03-2000 |
| | | | DE | 19618279 A1 | 13-11-1997 |
| | | | EP | 0806825 A2 | 12-11-1997 |
| | | | US | 6091591 A | 18-07-2000 |
| | | | US | 6094329 A | 25-07-2000 |
| JP S59165914 | A | 19-09-1984 | AUCUN | | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20140146424 A1
- US 6094329 A1

- JP S59165914 A